# EUROPEAN PATENT APPLICATION

(11) **EP 1 655 776 A1**
(43) Date of publication of application: **10.05.2006**
(21) Application number: 05024098.5
(22) Date of filing: 04.11.2005
(51) Int. Cl.: H01L 21/768, H01L 21/321

(54) **Polishing method**

(30) Priority: 05.11.2004 JP 2004322350
(71) Applicant: FUJIMI INCORPORATED, Nishibiwajima-cho, Kiyosu-shi Aichi 452-8502 (JP)
(72) Inventor: Oh, Junhui, Kiyosu-shi Aichi 452-8502 (JP); Kawamura, Atsunori, Kiyosu-shi Aichi 452-8502 (JP); Matsuda, Tsuyoshi, Kiyosu-shi Aichi 452-8502 (JP); Hirano, Tatsuhiko, Kiyosu-shi Aichi 452-8502 (JP); Hori, Katsunobu, Kiyosu-shi Aichi 452-8502 (JP); Sakai, Kenji, Kiyosu-shi Aichi 452-8502 (JP)
(74) Representative: Behnisch, Werner

(57) **Abstract**

A method for polishing an object to form wiring for a semiconductor device includes: removing part of an outside portion of a conductor layer through chemical and mechanical polishing to expose an upper surface of a barrier layer; and removing a remaining part of the outside portion of the conductor layer and an outside portion of the barrier layer through chemical and mechanical polishing to expose an upper surface of an insulator layer. When removing part of the outside portion of the conductor layer, the upper surface of the object is chemically and mechanically polished using a first polishing composition containing a film forming agent. Subsequently, the upper surface of the object is washed to remove a protective film formed on an upper surface of the conductor layer by the film forming agent in the first polishing composition. Thereafter, the upper surface of the object is chemically and mechanically polished again using a second polishing composition containing the film forming agent. Thus, the wiring of the semiconductor device is reliably formed.

## Description

### BACKGROUND OF THE INVENTION

The present invention relates to a method for chemically and mechanically polishing an object to form wiring for a semiconductor device.

The wiring for a semiconductor device is formed by first providing a barrier layer and a conductor layer on an insulator layer having trenches in this order. Thereafter, part of the conductor layer located outside the trenches (outside portion of the conductor layer) and part of the barrier layer located outside the trenches (outside portion of the barrier layer) are removed by chemical and mechanical polishing. The process for removing the outside portion of the conductor layer and the outside portion of the barrier layer generally includes a step of removing part of the outside portion of the conductor layer through chemical and mechanical polishing to expose the upper surface of the barrier layer, and a step of removing the remaining outside portion of the conductor layer and the outside portion of the barrier layer through chemical and mechanical polishing to expose the upper surface of the insulator layer. Japanese Laid-Open Patent Publications No. 8-83780, No. 10-116804, and International Publication No. 00/13217 disclose polishing compositions used in chemical and mechanical polishing for removing part of an outside portion of a conductor layer.

However, when chemical and mechanical polishing is performed using the polishing composition disclosed in any of the above publications Nos. 8-83780, 10-116804, and 00/13217, there is a risk that part of the conductor layer that should be removed, that is, the outside portion of the conductor layer could remain, or part of the conductor layer other than the part of the conductor layer that should be removed, that is, part of the conductor layer located inside the trenches (inside portion of the conductor layer) could be removed. If part of the outside portion of the conductor layer remains, the residual dross causes a short-circuit, which decreases the production yield of the semiconductor device or the quality of the semiconductor device. Contrastingly, if the inside portion of the conductor layer is removed, a phenomenon called dishing occurs in which the level of the upper surface of the conductor layer is decreased. This increases the wiring resistance or decreases the flatness of the surface.

### SUMMARY OF THE INVENTION

Accordingly, it is an objective of the present invention to provide a polishing method that reliably forms the wiring for a semiconductor device.

To achieve the foregoing and other objectives, a method for chemically and mechanically polishing an object to form wiring for a semiconductor device is provided. The object includes an insulator layer having a trench, a barrier layer provided on the insulator layer, and a conductor layer provided on the barrier layer. The barrier layer and the conductor layer each have an outside portion located outside the trench and an inside portion located inside the trench. The method includes: removing part of the outside portion of the conductor layer through chemical and mechanical polishing to expose an upper surface of the barrier layer; and removing the remaining part of the outside portion of the conductor layer and the outside portion of the barrier layer through chemical and mechanical polishing to expose an upper surface of the insulator layer after removing part of the outside portion of the conductor layer. The step of removing part of the outside portion of the conductor layer includes:
chemically and mechanically polishing an upper surface of the object using a first polishing composition containing a film forming agent; washing the upper surface of the object that has been chemically and mechanically polished, thereby removing a protective film formed on the upper surface of the conductor layer by the film forming agent in the first polishing composition; and chemically and mechanically polishing the upper surface of the washed object using a second polishing composition containing a film forming agent.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:

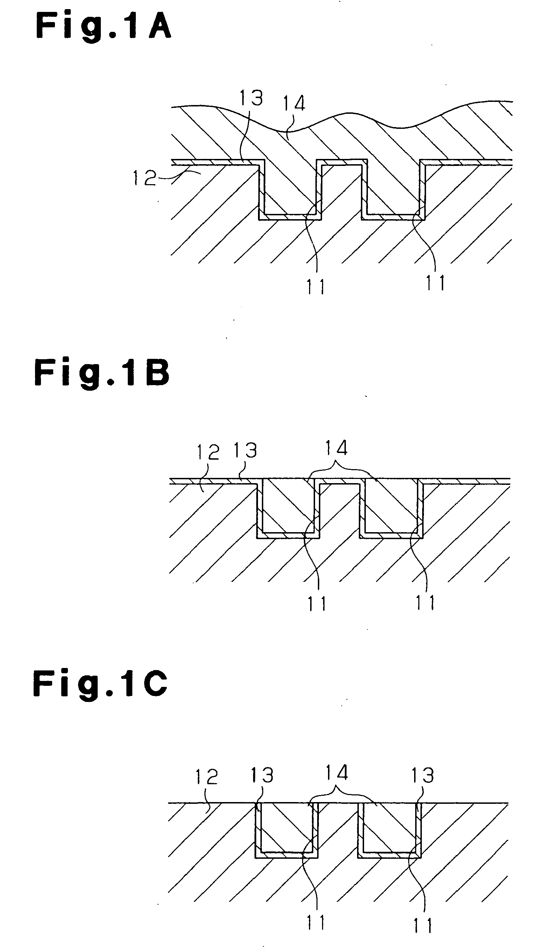

Figs. 1A to 1C are cross-sectional views illustrating an object to explain a polishing method according to one embodiment of the present invention.

### DETAILED DESCRIPTION OF THE PREFERRED EMBODIMENTS

One embodiment of the present invention will now be described.

In this embodiment, wiring for a semiconductor device is formed in the following manner. First, as shown in Fig. 1A, a barrier layer 13 and a conductor layer 14 are formed on an insulator layer 12 having trenches 11.

The insulator layer 12 is formed of, for example, silicon oxide through chemical vapor deposition (CVD). The trenches 11 are formed in the insulator layer 12 to have a predetermined design pattern using, for example, a lithography technique and a pattern etching technique.

The barrier layer 13 is formed on the insulator layer 12 before forming the conductor layer 14, and is located between the insulator layer 12 and the conductor layer 14. The barrier layer 13 is formed of, for example, tantalum or tantalum nitride using a sputtering technique. It is desired that the thickness of the barrier layer 13 be sufficiently smaller than the depth of the trenches 11.

The conductor layer 14 is formed on the insulator layer 12 subsequently to formation of the barrier layer 13, and is located on the barrier layer 13 to at least fill the trenches 11. The conductor layer 14 is formed of copper or a copper alloy through, for example, plating or physical vapor deposition (PVD).

After forming the barrier layer 13 and the conductor layer 14, part of the conductor layer 14 located outside the trenches 11 (the outside portion of the conductor layer 14) and part of the barrier layer 13 located outside the trenches 11 (the outside portion of the barrier layer 13) are removed by chemical and mechanical polishing. Thus, part of the barrier layer 13 located inside the trenches 11 (the inside portion of the barrier layer 13) and part of the conductor layer 14 located inside the trenches 11 (the inside portion of the conductor layer 14) remain on the insulator layer 12. The inside portion of the conductor layer 14 functions as the wiring of the semiconductor device, and the inside portion of the barrier layer 13 prevents dispersion of metal atoms (for example, copper atoms) in the inside portion of the conductor layer 14 to the insulator layer 12.

When the outside portion of the conductor layer 14 and the outside portion of the barrier layer 13 are removed through chemical and mechanical polishing, firstly, part of the outside portion of the conductor layer 14 is removed through chemical and mechanical polishing (first polishing step) as shown in Fig. 1B to expose the upper surface of the barrier layer 13. Subsequently, the remaining part of the outside portion of the conductor layer 14 and the outside portion of the barrier layer 13 are removed through chemical and mechanical polishing (second polishing step) as shown in Fig. 1C to expose the upper surface of the insulator layer 12.

Part of the outside portion of the conductor layer 14 is removed through chemical and mechanical polishing by first chemically and mechanically polishing (main polishing sub-step) the upper surface of an object including the insulator layer 12, the barrier layer 13, and the conductor layer 14. Subsequently, the upper surface of the object is washed (washing sub-step). Thereafter, the upper surface of the object is chemically and mechanically polished again (auxiliary polishing sub-step).

In the first chemical and mechanical polishing performed before washing, a first polishing composition containing a film forming agent is used. The film forming agent reacts with material forming the conductor layer 14 thereby forming a protective film on the upper surface of the conductor layer 14. The protective film formed on the upper surface of the conductor layer 14 by the film forming agent suppresses excessive polishing of the conductor layer 14 to prevent dishing. The film forming agent in the first polishing composition is preferably a surface active agent, but may contain a small amount of benzotriazole or its derivatives. The chemical and mechanical polishing using the first polishing composition is performed by placing a polishing member such as a polishing pad in contact with the upper surface of the object with a predetermined pressure, and sliding either the object or the polishing member while feeding the first polishing composition to the polishing member. The polishing pressure during the chemical and mechanical polishing is preferably around 140 hPa.

Washing performed subsequent to the first chemical and mechanical polishing is for removing the protective film formed on the upper surface of the conductor layer 14 by the film forming agent in the first polishing composition. The washing procedure may include, for example, polishing, rinsing, or scrubbing. However, when polishing is performed, fluid supplied to the polishing member when sliding either the object or the polishing member is preferably water such as purified water instead of the polishing composition.
Polishing performed while being supplied with water is specifically referred to as water polishing. In a case of water polishing, unlike general polishing using a polishing composition, there is no risk that a protective film could be formed on the upper surface of the conductor layer 14 while polishing. Furthermore, unlike rinsing or scrubbing, water polishing can be performed using a polishing device for chemical and mechanical polishing before and after the washing. Therefore, it is unnecessary to prepare a washing device for the washing sub-step, nor to move the object between the polishing device used for the main polishing sub-step and the auxiliary polishing sub-step and the washing device used for the washing sub-step.

When the feed rate of water during the water polishing is 200 mL/minute or less, or more specifically less than 1000 mL/minute, the protective film on the upper surface of the conductor layer 14 is not sufficiently removed. As a result, there is a risk that part of the conductor layer 14 that should be removed could remain on the barrier layer 13 by a small amount. Therefore, the feed rate of water during the water polishing is preferably 200 mL/minute or more, and more preferably 1000 mL/minute or more. However, even in a case where the feed rate is 200 mL/minutes or less, if the washing time is extended, the protective film on the upper surface of the conductor layer 14 can be sufficiently removed.

In a second chemical and mechanical polishing performed subsequent to washing, a second polishing composition containing a film forming agent is used. The composition of the second polishing composition may be different from that of the first polishing composition. However, when the composition of the second polishing composition is the same as that of the first polishing composition, the commonality of the first polishing composition and the second polishing composition is achieved. When the first polishing composition and the second polishing composition are the same, not only is the polishing process simplified and the cost accordingly reduced, but also problems caused due to mixing of the first polishing composition and the second polishing composition during the auxiliary polishing sub-step are avoided. The chemical and mechanical polishing using the second polishing composition is performed by placing a polishing member such as a polishing pad in contact with the upper surface of the object with a predetermined pressure, and sliding either the object or the polishing member while feeding the second polishing composition to the polishing member.

When the polishing pressure during the chemical and mechanical polishing after washing is equal to or greater than the polishing pressure during the chemical and mechanical polishing before washing, there is a risk that slight dishing could occur on the object after polishing. Therefore, the polishing pressure during chemical and mechanical polishing after washing is preferably less than the polishing pressure during chemical and mechanical polishing before washing. Furthermore, when the polishing pressure during chemical and mechanical polishing after washing is greater than 50 hPa, or more specifically greater than 10 hPa, there is a risk that slight dishing could occur on the object after polishing. Therefore, the polishing pressure during chemical and mechanical polishing after washing is preferably 50 hPa or less, and more preferably 10 hPa or less.

The preferred embodiment has the following advantages.

During the first polishing step for removing part of the outside portion of the conductor layer 14, after the upper surface of the object is subjected to chemical and mechanical polishing, the upper surface of the object is washed, and thereafter the upper surface of the object is subjected to chemical and mechanical polishing again. In a case where part of the conductor layer 14 that should be removed remains after the first chemical and mechanical polishing, even if chemical and mechanical polishing is continued instead of executing washing, the residual dross is not removed significantly since a protective film is formed on the upper surface of the residual dross by the film forming agent in the first polishing composition. Even worse, there is a risk that part of the conductor layer 14 other than the part of the conductor layer 14 that should be removed (the inside portion of the conductor layer 14) could be removed. Contrastingly, if washing is performed subsequent to the first chemical and mechanical polishing, the residual dross of the conductor layer 14 is removed by performing chemical and mechanical polishing again after washing since the protective film on the residual dross of the conductor layer 14 is removed. Furthermore, since the second polishing composition used in the chemical and mechanical polishing after washing contains the film forming agent, dishing is prevented from occurring by the film forming agent. Thus, the wiring of the semiconductor device is reliably formed.

If part of the conductor layer 14 that should be removed remains after the first polishing step for removing part of the outside portion of the conductor layer 14, the residual dross of the conductor layer 14 needs to be removed simultaneously during the second polishing step for removing the remaining part of the outside portion of the conductor layer 14 and the outside portion of the barrier layer 13. In such a case, setting of conditions for chemical and mechanical polishing of the second polishing step becomes complicated. Contrastingly, when washing is performed in the middle of the first polishing step as described above, part of the conductor layer 14 that should be removed is more reliably removed. Thus, setting of the conditions for chemical and mechanical polishing of the second polishing step does not become complicated.

Next, examples and comparative examples of the present invention are explained.

854 mask pattern wafers manufactured by SEMATECH including a barrier layer made of tantalum and a conductor layer made of copper were prepared. In examples 1 to 6 and comparative examples 1 to 8, part of the outside portion of the conductor layer was removed by chemical and mechanical polishing to expose the upper surface of the barrier layer. Details of the main polishing sub-step for chemically and mechanically polishing the upper surface of the wafer, the washing sub-step for thereafter washing the upper surface of the wafer through water polishing, and the auxiliary polishing sub-step for thereafter chemically and mechanically polishing the upper surface of the wafer again are shown in Tables 1 and 2. The polishing pad used in each sub-step was a polyurethane pad, the sweep width of the polishing head was 40 mm, the guide ring pressure was 350 hPa, the temperature of the polishing composition supplied to the polishing pad during the main polishing sub-step and the auxiliary polishing sub-step and the temperature of water supplied to the polishing pad during washing sub-step were room temperature. The composition of the polishing composition used in the main polishing sub-step and the composition of the polishing composition used in the auxiliary polishing sub-step are as shown in Table 3.

Numerical values in the column entitled "Feed rate" in Tables 1 and 2 represent the feed rate of the polishing composition or washing water to the polishing pad. Numerical values in the column entitled "Polishing pressure" in Tables 1 and 2 represent the contact pressure between the wafer and the polishing pad. Numerical values in the column entitled "Linear velocity" in Tables 1 and 2 represent the relative linear velocity between the wafer and the polishing pad. Numerical values in the column entitled "Sweep rate" in Tables 1 and 2 represent the number of sweeps of the polishing head per unit time. Numerical values in the column entitled "Polishing amount" in Tables 1 and 2 show that chemical and mechanical polishing is executed for a period of time required to polish the conductor layer having the indicated thickness. Numerical values in the column entitled "Washing time" in Tables 1 and 2 represent the execution time of the water polishing.

The dishing depths of wafers after polishing were measured in accordance with measuring conditions shown in Table 4. More specifically, the dishing depth in a high density wiring area where the trenches having the widths of 9 µm are arranged at 1 µm intervals, the dishing depth in a medium density wiring area where the trenches having the widths of 10 µm are arranged at 10 µm intervals, and the dishing depth in a low density wiring area where the trenches having the widths of 100 µm are arranged at 100 µm intervals were measured. The dishing depth measured in the high density wiring area is shown in the column entitled "Dishing amount^{*1}" in Tables 1 and 2, the dishing depth measured in the medium density wiring area is shown in the column entitled "Dishing amount^{*2}" in Tables 1 and 2, and the dishing depth measured in the low density wiring area is shown in the column entitled "Dishing amount^{*3}" in Tables 1 and 2.

The wafers that had been polished were observed using an optical microscope at a magnification of 50 times. Based on whether part of the conductor layer remained that should have been removed, the wafers that had been polished were evaluated according to a two rank scale: good and poor. That is, if part of the conductor layer that should have been removed did not remain, it was ranked good, and if part of the conductor layer remained that should have been removed, it was ranked poor. The evaluation results are shown in the column entitled "Existence or nonexistence of residual dross" in Tables 1 and 2.

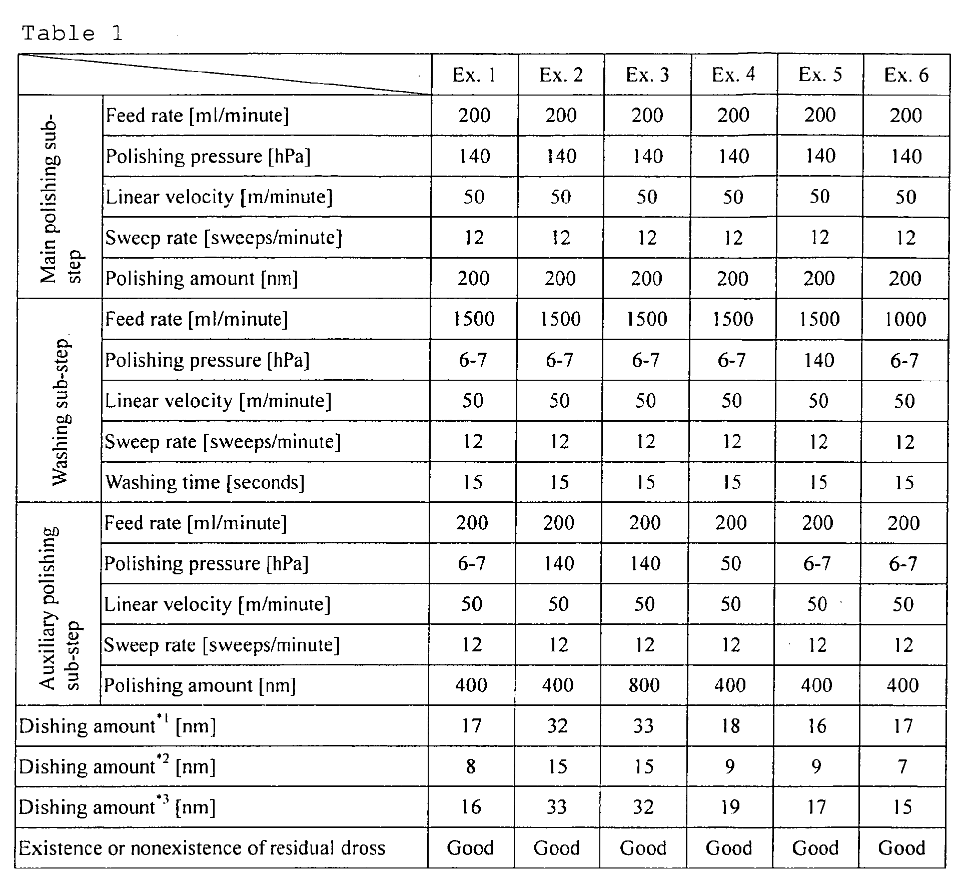

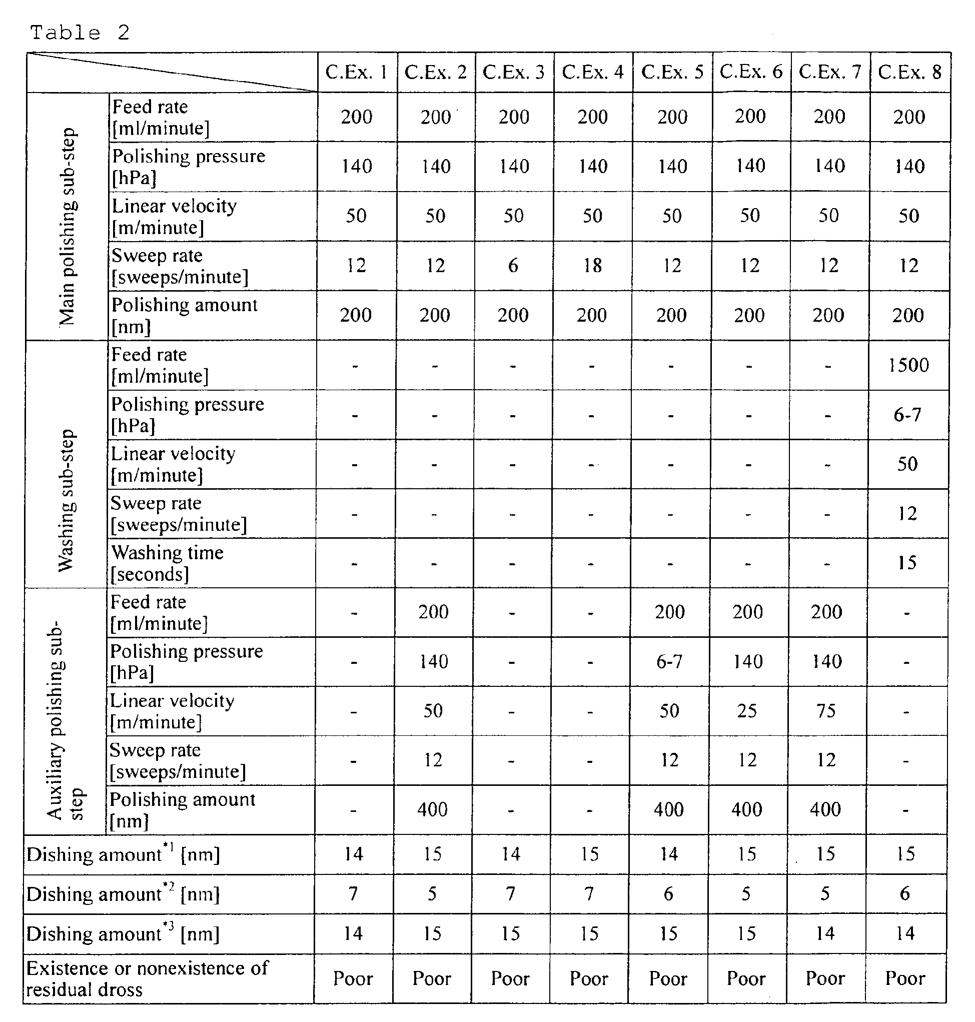

**Table 3**

| |
|---|
| Abrasive: colloidal silica (content of 4.8 g/L) having an average primary particle size of 23 nm, as measured through a BET method |
| Polishing accelerator: α-alanine (content of 3.0 g/L) |
| Film forming agent: benzotriazole derivative (content of 0.08 g/L) + anion surface active agent (content of 1.6 g/L) |
| pH adjuster: KOH (content of 7.2 g/L) |
| Oxidant: ammonium persulfate (content of 10 g/L) |
| Water: remaining part |

**Table 4**

| |
|---|
| Measuring device: "HRP340" manufactured by KLA-Tencor Corporation |
| Stylus: "Sub-µm Stylus" |
| Stylus pressure: approximately 7.8 µN (0.8 mgf) |
| Stylus speed: 10 µm/second |

As shown in Table 2, in comparative examples 1 to 8, the dishing depths measured after polishing were small, but part of the conductor layer remained that should have been removed. Contrastingly, as shown in Table 1, in examples 1 to 6, part of the conductor layer that should be removed was completely removed, and the dishing depths measured after polishing were not great. The results suggest that the wiring for the semiconductor device was reliably formed according to the polishing method of the present invention. Furthermore, the dishing depths measured in examples 1 and 4 were smaller than the dishing depths measured in examples 2 and 3. The results suggest that the dishing depth is decreased by setting the polishing pressure during chemical and mechanical polishing after washing lower than the polishing pressure during chemical and mechanical polishing before washing, or more specifically by setting the polishing pressure during the chemical and mechanical polishing after washing to 50 hPa or less.

## Claims

1. A method for chemically and mechanically polishing an object to form wiring for a semiconductor device, the object including an insulator layer having a trench, a barrier layer provided on the insulator layer, and a conductor layer provided on the barrier layer, wherein the barrier layer and the conductor layer each have an outside portion located outside the trench and an inside portion located inside the trench, the method **characterized by**:
removing part of the outside portion of the conductor layer through chemical and mechanical polishing to expose an upper surface of the barrier layer; and
removing the remaining part of the outside portion of the conductor layer and the outside portion of the barrier layer through chemical and mechanical polishing to expose an upper surface of the insulator layer after removing part of the outside portion of the conductor layer,
wherein said removing part of the outside portion of the conductor layer includes:
chemically and mechanically polishing an upper surface of the object using a first polishing composition containing a film forming agent;
washing the upper surface of the object that has been chemically and mechanically polished, thereby removing a protective film formed on the upper surface of the conductor layer by the film forming agent in the first polishing composition; and
chemically and mechanically polishing the upper surface of the washed object using a second polishing composition containing a film forming agent.

2. The method according to claim 1, **characterized in that** said washing of the upper surface of the object that has been chemically and mechanically polished is performed through water polishing.

3. The method according to claim 2, **characterized in that** the feed rate of water during the water polishing is 200 mL/minute or more.

4. The method according to claim 3, **characterized in that** the feed rate of water during the water polishing is 1000 mL/minute or more.

5. The method according to any one of claims 1 to 4, **characterized in that** the compositions of the first polishing composition and the second polishing composition are the same, and the polishing pressure when chemically and mechanically polishing the upper surface of the washed object using the second polishing composition is lower than the polishing pressure when chemically and mechanically polishing the upper surface of the object using the first polishing composition.

6. The method according to any one of claims 1 to 4, **characterized in that** the compositions of the first polishing composition and the second polishing composition are the same, and the polishing pressure when chemically and mechanically polishing the upper surface of the washed object using the second polishing composition is 50 hPa or less.

7. The method according to claim 6, **characterized in that** the polishing pressure when chemically and mechanically polishing the upper surface of the washed object using the second polishing composition is 10 hPa or less.

8. The method according to any one of claims 1 to 7, **characterized in that** the film forming agent in the first polishing composition is a surface active agent.

9. The method according to any one of claims 1 to 8, **characterized in that** the conductor layer is formed of copper or a copper alloy.
